(19) **Europäisches Patentamt**
**European Patent Office**
**Office européen des brevets**

(11) **EP 3 049 549 B1**

(12) **EUROPEAN PATENT SPECIFICATION**

(45) Date of publication and mention
of the grant of the patent:
**20.03.2019 Bulletin 2019/12**

(51) Int Cl.:
*C23C 18/24* (2006.01)       *C23C 18/54* (2006.01)
*H05K 3/00* (2006.01)        *C23G 1/10* (2006.01)

(21) Application number: **14758972.5**

(22) Date of filing: **05.09.2014**

(86) International application number:
**PCT/EP2014/068914**

(87) International publication number:
**WO 2015/043920 (02.04.2015 Gazette 2015/13)**

(54) **METHOD FOR TREATMENT OF RECESSED STRUCTURES IN DIELECTRIC MATERIALS FOR SMEAR REMOVAL**

VERFAHREN ZUR BEHANDLUNG VON VERTIEFTEN STRUKTUREN IN DIELEKTRISCHEN MATERIALIEN FÜR DIE ABSTRICHENTFERNUNG

PROCÉDÉ DE TRAITEMENT DE STRUCTURES ÉVIDÉES DANS DES MATÉRIAUX DIÉLECTRIQUES POUR ÉLIMINER LES TÂCHES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.09.2013 EP 13185890**

(43) Date of publication of application:
**03.08.2016 Bulletin 2016/31**

(73) Proprietor: **Atotech Deutschland GmbH**
**10553 Berlin (DE)**

(72) Inventors:
• **STEINHÄUSER, Edith**
**10315 Berlin (DE)**
• **WIESE, Stefanie**
**10825 Berlin (DE)**
• **GREGORIADES, Laurence John**
**10439 Berlin (DE)**
• **SCHIEMANN, Julia**
**10245 Berlin (DE)**
• **STAMP, Lutz**
**13509 Berlin (DE)**

(56) References cited:
**EP-A1- 0 387 057        EP-A1- 0 887 439**
**WO-A1-98/05516        DE-A1- 2 010 438**
**US-A1- 2013 186 764**

## Description

### Field of the Invention

The present invention relates to a method for treatment of recessed structures in dielectric materials for smear removal in the manufacture of printed circuit boards and IC substrates.

### Background of the Invention

Recessed structures such as through holes (THs) and blind micro vias (BMVs) need to be formed in dielectric materials and later plated with copper to provide an electrical contact between individual layers of a multilayer printed circuit board, IC substrate and related devices. Said recessed structures are for example formed by mechanical drilling, laser drilling or plasma erosion. The smear (residues from the dielectric material) created during formation of said recessed structures needs to be removed from the dielectric material, copper structures and/or copper layer(s) before the dielectric walls of the recessed structures are activated for successive conformal plating or filling with copper by electroplating. Smear not removed causes an insufficient adhesion of the copper later deposited onto the dielectric walls of the recessed structures.

The dielectric material in which the recessed structures are formed contains a thermoplastic polymer, for example an epoxy resin, polyimide, cyanate esters and polyester. Such dielectric materials usually comprise also a second material for reinforcement such as glass fibers and/or glass balls and in addition copper structures and/or copper layer(s).

The current standard method for removal of smear comprises three steps:

> 1. swelling the dielectric material with an alkaline aqueous solution comprising an organic solvent,
> 2. etching the dielectric materials with an alkaline solution comprising permanganate ions and
> 3. reducing $MnO_2$ formed during etching.

Alternative methods using highly acidic media for etching such as permanganate ions in concentrated sulfuric acid or chromic acid are also known in the art but have no practical relevance. Both permanganate ions and chromic acid need to be replaced because of their toxic properties. A technological disadvantage of known acidic methods for removal of smear is that siloxane-ether linkers between the glass reinforcement and the thermoplastic polymer in the dielectric material are broken and process chemicals can penetrate into the dielectric material and cause a failure known as "wicking".

A method for smear removal utilizing an oxidizing agent in concentrated sulfuric acid (at least 92 wt.-%) is disclosed in EP 0 216 513. The strong acidic solution causes undesired "wicking" and furthermore leads to an undesirable high etching rate of copper during removal of smear. This high copper etching rate is not acceptable especially in case of fine copper structures and/or thin copper layers present in recent printed circuit boards and IC substrates.

An aqueous solution comprising 705 g/l of $H_2SO_4$ 95% and 50 g/l of $(NH_4)_2S_2O_8$ used in the treatment of an unstructured resin surface and equally of an recessed structure in a dielectric material such as a phenol-aldehyde-epoxy resin is disclosed in DE2010438 A1.

An aqueous solution of 200 g/l ammonium peroxodisulfate for the removal of metal burrs caused by laser drilling is disclosed in US 4,023,998. This method is not suitable to remove smear from the dielectric material (Example 2 (comparative)).

### Objective of the present Invention

The objective of the present invention is to provide a reliable method for smear removal after formation of recessed structures in dielectric materials during the manufacture of printed circuit boards and IC substrates which avoids toxic chemicals such as permanganate ions and chromic acid and which suppresses undesired phenomena such as penetration of process chemicals into the dielectric material ("wicking") and a too strong etching of copper structures and/or copper layer(s). Furthermore, the number of process steps should be reduced compared to known methods such as the alkaline method with permanganate ions. The shelf life of the aqueous solution used in a method for smear removal should be sufficient, also in the presence of copper ions which are enriched in such an aqueous solution during use in the manufacture of printed circuit boards and IC substrates.

### Summary of the Invention

These objectives are solved by a method for treatment of recessed structures in a dielectric material for smear removal comprising, in this order, the steps of

(i) providing a dielectric substrate comprising at least one recessed structure which contains residues of said dielectric material formed during manufacture of said recessed structures and

(ii) contacting said dielectric substrate with an aqueous solution comprising 60 to 80 wt.-% sulfuric acid and 0.04 to 0.66 mol/l peroxodisulfate ions and thereby removing said residues of dielectric material from the dielectric substrate

wherein said aqueous solution further comprises at least one stabilizer additive selected from the group consisting of alcohols, molecular ethers and polymeric ethers.

The method for treatment of recessed structures in a dielectric material according to the present invention does not utilize toxic materials such as permanganate ions and chromic acid. Etching of copper is low as desired and smear removal from the dielectric material is sufficiently high as determined by the weight loss of dielectric material when applying the method according to the present invention. Furthermore, undesired penetration of process chemicals into the dielectric material ("wicking") is suppressed because the siloxane-ether linkers between the glass reinforcement and the thermoplastic polymer in the dielectric material are not broken. Also the number of process steps is reduced, because the reducing step required when using permanganate ions is not required in the method according to the present invention. Furthermore, the copper etching rate is sufficiently low. The stabilizing additive present in the aqueous solution provides a sufficient shelf time of said aqueous solution during use even in the presence of copper ions.

In a preferred embodiment of the present invention, the swelling step with an aqueous solution comprising an organic solvent is also not required.

Hence, the method according to the present invention is well suited to clean the recessed structures of dielectric materials after formation of said recessed structures and leading to a desirably high adhesion between the copper electroplated into the recessed structures in successive process steps and the dielectric material.

## Detailed Description of the Invention

Recessed structures (THs, BMVs) are usually formed by mechanical drilling, laser drilling or plasma erosion. Other structures such as trenches can also be formed by embossing techniques. In all those cases smear consisting of residues of the thermoplastic polymer in the dielectric material is formed which has to be completely removed prior to activation of the dielectric walls of the recessed structures for successive electroplating of copper. The exact chemical nature of said smear may vary depending on the method applied for manufacture of the recessed structures. The method according to the present invention is capable to remove smear formed by all standard drilling methods, independent of the exact chemical nature of the smear.

Dielectric materials to be treated with the method according to the present invention are based on thermoplastic polymers such as epoxy resins, polyimide, cyanate esters, polyester, acrylonitrile-butadiene-styrene copolymer (ABS), poly-carbonates (PC), ABS-PC composites (acrylonitrile-butadiene-styrene - polycarbonate composites, also denoted ABS-PC blends), polyamide (PA) and polycyclo-olefine. Dielectric materials preferably comprise also a glass reinforcement such as glass fibers and/or glass balls. The thermoplastic polymer and the glass reinforcement are chemically connected by siloxane-ether linkers in order to form a stable composite material.

The dielectric material preferably further comprises copper structures and/or one or more copper layers.

A dielectric material comprising recessed structures is provided in step (i) of the method according to the present invention after those recessed structures have been formed.

The dielectric substrate is then contacted in step (ii) of the method according to the present invention with an aqueous solution comprising 60 to 80 wt.-% sulfuric acid, preferably 65 to 75 wt.-% sulfuric acid.

Said aqueous solution further comprises 0.04 to 0.66 mol/l peroxodisulfate ions, preferably 0.12 to 0.44 mol/l peroxodisulfate ions.

Water-soluble peroxodisulfate salts may be used to provide the required amount of peroxodisulfate ions in said aqueous solution. Suitable water-soluble peroxodisulfate salts are sodium peroxodisulfate, potassium peroxodisulfate, ammonium peroxodisulfate and mixtures of the aforementioned. Also peroxodi-sulfuric acid can be used alone as the source for peroxodisulfate ions or in a mixture together the aforementioned water-soluble peroxodisulfate salts. Ammonium peroxodisulfate is the most preferred source for peroxodisulfate ions because it is the most stable source for peroxodisulfate ions in the aqueous solution according to the present invention.

The concentration range of sulfuric acid in the aqueous solution applied in step (ii) of the method according to the present invention is mandatory because a sulfuric acid concentration too low does not remove the residues of the dielectric material after formation of the recessed structures. A sulfuric acid concentration too high leads to the undesired penetration of process chemicals into the dielectric material ("wicking") because the siloxane-ether linkers between the thermoplastic polymer and the glass reinforcement of the dielectric material are broken.

The concentration of peroxodisulfate ions must be kept within the above mentioned margins because a concentration too low does not sufficiently remove smear of the dielectric material after formation of the recessed structures and a concentration too high leads to undesired precipitation of solid material in the aqueous solution.

The stability of aqueous solutions comprising 60 to 80 wt.-% sulfuric acid and 0.04 to 0.66 mol/l peroxodisulfate ions decreases, particularly in the presence of copper ions. The stability of said aqueous solution is determined by the concentration of the oxidizing agent peroxodisulfate ions. Accordingly, the desired smear removal capability of such a aqueous solution drops during use and the method for smear removal is not reliable enough for practical use in the manufacture of printed circuit boards where copper ions are enriched in such aqueous solutions.

Therefore, the aqueous solution applied in step (ii) of the method according to the present invention further comprises at least one stabilizer additive selected from the group consisting of alcohols, molecular ethers and polymeric ethers.

Suitable alcohols are selected from the group consisting of methanol, ethanol, 1-propanole, 2-propanole, 1-butanole, 2-butanole, tert-butanole, 1-pentanol, 2-pentanol, ethylene glycol, propylene glycol, butyl glycol, glycerine and polyvinylalcohol.

Suitable molecular ethers are selected from the group consisting of ethylene glycol monoethyl ether, ethylene glycol monobutyl ether, propylene glycol monomethyl ether, propylene glycol monoethyl ether, propylene glycol monobutyl ether, diethylene glycol monomethyl ether, diethylene glycol monoethyl ether, diethylene glycol monopropyl ether, diethylene glycol monobutyl ether, dipropylene glycol monomethyl ether, dipropylene glycol monoethyl ether, dipropylene glycol monopropyl ether, dipropylene glycol monobutylether, triethylene glycol monomethyl ether, triethylene glycol monoethyl ether, triethylene glycol monopropyl ether, triethylene glycol monobutyl ether, tripropylene glycol monomethyl ether, tripropylene glycol monoethyl ether, tripropylene glycol monopropyl ether, tripropylene glycol monobutyl ether and diethylene glycol monoisopropyl ether.

Suitable polymeric ethers are selected from the group consisting of poly-ethyleneglycol, poly-propyleneglycol, poly-(ethyleneglycol-*ran*-propyleneglycol), poly-(ethyleneglycol)-*block*-poly-(propyleneglycol)-*block*-poly-(ethyleneglycol), and poly-(propyleneglycol)-*block*-poly-(ethyleneglycol)-*block*-poly-(propyleneglycol).

Most preferably, the stabilizer additive is a polymeric ether.

The concentration of the stabilizer additive selected from the group consisting of alcohols, molecular ethers and polymeric ethers preferably ranges from 0.5 to 300 mmol/l, more preferably from 1 to 150 mmol/l.

The presence of said at least one stabilizer additive strongly improves the shelf life of said aqueous solution used in step (ii) of the method according to the present invention without negatively influencing the weight loss of dielectric material and the copper etch rate (i.e. the desired properties for smear removal in the manufacture of printed circuit boards and the like). Accordingly, the method is considered reliable and useful for the manufacture of printed circuit boards and IC substrates. The aqueous solution used in step (ii) optionaly further comprises a complexing agent for copper ions. Suitable complexing agents for copper ions are preferably selected from the group comprising aminocarboxylic acids, phosphonates and salts of the aforementioned. Suitable salts of the aforementioned complexing agents for copper ions are for example sodium and potassium salts.

Suitable aminocarboxylic acids are for example ethylenediamine tetraacetic acid, ethylenediamine monosuccinic acid, diethylenetriamine monosuccinic acid, triethylenetetraamine monosuccinic acid, 1,6-hexamethylenediamine monosuccinic acid, tetraethylenepentamine monosuccinic acid, 2-hydroxypropylene-1,3-diamine monosuccinic acid, 1,2-propylenediamine monosuccinic acid, 1,3-propylenediamine monosuccinic acid, cis-cyclohexanediamine monosuccinic acid, trans-cyclohexanediamine monosuccinic acid, ethylenebis-(oxyethylenenitrilo) monosuccinic acid, ethylenediamine-N,N'-disuccinic acid, diethylenetriamine-N,N''-disuccinic acid, triethylenetetraamine-N,N'''-disuccinic acid, 1,6-hexamethylenediamine N,N'-disuccinic acid, tetraethylenepentamine-N,N''''-disuccinic acid, 2-hydroxypropylene-1,3-diamine-N,N'-disuccinic acid, 1,2 propylenediamine-N,N'-disuccinic acid, 1,3-propylenediamine-N,N''-disuccinic acid, cis-cyclohexanediamine-N,N'-disuccinic acid, transcyclohexanediamine-N,N'-disuccinic acid, and ethylenebis-(oxyethylenenitrilo)-N,N'-disuccinic acid. Suitable phosphonates are for example nitrilotris-(methylene phosphonic acid), ethane-1,2-bis-(iminobis-(methylene-phosphonic acid)), 1-hydroxyethane-1,1,-diphosphonic acid, hydroxyethyl-amino-di-(methylene phosphonic acid), carboxymethyl-amino-di-(methylene phosphonic acid), amino-tris-(methylene phosphonic acid), nitrilo-tris-(methylene phosphonic acid), ethylendiamine-tetra-(methylene phosphonic acid), hexamethylendiamino-tetra-(methylene phosphonic acid), N-(phosphonomethyl) imidodiacetic acid, diethylenetriamine-N,N,N',N'',N''-penta-(methylphosphonic acid), 2-butane phosphonate 1,2,4-tricarboxylic acid, and 2-phosphonobutane-1,2,4-tricarboxylic acid.

The concentration of the optional complexing agent for copper ions preferably ranges from 0.5 to 500 mmol/l, more preferably from 1 to 300 mmol/l.

The presence of a complexing agent for copper ions in the aqueous solution used in step (ii) of the method according to the present invention further improves the shelf life of said aqueous solution during use, particularly when copper ions are enriched in said aqueous solution.

The aqueous solution optionally further comprises a corrosion inhibitor for copper such as a triazole compound (e.g. benzotriazole). Such corrosion inhibitors are known in the art. The concentration of the optional corrosion inhibitor for copper preferably ranges from 0.1 to 1000 mg/l, more preferably from 1 to 500 mg/l.

The dielectric substrate is contacted with the aqueous solution in step (ii) of the method according to the present invention preferably for 1 to 60 min, more preferably for 5 min to 40 min and most preferably for 10 min to 30 min.

The temperature of the aqueous solution is held in step (ii) of the method according to the present invention in the range of preferably 10 to 80 °C, more preferably 20 to 60 °C and most preferably 20 to 40 °C.

The method for treatment of recessed structures in dielectric materials for smear removal according to the present invention can be applied various types of equipment such as horizontal equipment, vertical equipment and vertically conveyorized equipment.

The dielectric substrate is optionally contacted with an aqueous solution comprising an organic solvent prior to step (ii). The organic solvent is for example a glycol such as butyl diglycol or an N-alkyl pyrrolidone such as N-methyl pyrrolidone and N-ethyl pyrrolidone. The concentration of the organic solvent preferable ranges from 20 to 80 wt.-%. Mixtures of solvents may also be used. The dielectric substrate is optionally contacted with said aqueous solution at a temperature in the range of 30 to 90 °C for 1 to 20 min. When contacting the dielectric substrate with said aqueous solution, the thermoplastic polymer of the dielectric substrate swells and thereby the smear removal in step (ii) can be supported.

In one embodiment of the present invention, the dielectric substrate is rinsed after step (ii) with water comprising an alkaline substance, such as an alkali metal hydroxide (e.g. sodium hydroxide, potassium hydroxide, ammonium hydroxide and mixtures thereof). The pH-value of the alkaline rinse preferably ranges from 7 to 14. The alkaline rinse is necessary for the removal of organic residues arising from the oxidation of the dielectric substrate.

In one embodiment of the present invention, process step (ii) is supported by ultrasonic sound. The aqueous solution applied in step (ii) is in this embodiment agitated by means of ultrasonic equipment.

A support by ultrasonic sound during step (ii) of the method according to the present invention may be combined with a rinse with water containing an alkaline substance after step (ii).

The dielectric substrate having recessed structures is then suited for activation and successive copper plating and a sufficiently high adhesion between the dielectric substrate and the plated copper layer is achieved. Furthermore, undesired penetration of process chemicals in successive steps after applying the method according to the present invention is suppressed because the thermoplastic polymer and the glass reinforcement still adhere to each other.

A further technical advantage of the method according to the present invention compared to other acidic solutions utilized for removal of smear is the low copper etching rate during step (ii). This means that only a very small amount of copper is etched away when contacting the dielectric substrate with the acidic solution in step (ii). A low copper etching rate is particularly desired when the dielectric substrate comprises very fine copper structures and/or thin copper layers which should not be attacked by the acidic treatment solution applied in step (ii). The copper etching rate during step (ii) should not exceed 0.2 $\mu$m/min.

Activation of the dielectric substrate after smear removal (step (iii)) is preferably achieved by contacting said dielectric substrate with a solution comprising ions and/or colloids of a catalytic metal which initiates electroless copper plating. Such catalytic active metals are for example palladium, silver and copper. Applicable activator compositions providing the catalytic metal in ionic or colloidal form are for example disclosed in ASM Handbook, Vol. 5 Surface Engineering, 1194, p. 317-318.

Next, the activated dielectric substrate is contacted in step (iv) of the method according to the present invention with an electroless copper plating bath composition and thereby depositing a first copper layer onto the activated dielectric substrate.

Electroless copper plating electrolytes comprise for example a source of copper ions, pH modifiers, complexing agents such as EDTA, alkanol amines or tartrate salts, accelerators, stabilizer additives and a reducing agent. In most cases formaldehyde is used as reducing agent, other common reducing agents are hypophosphite, glyoxylic acid, dimethylamine borane and sodium borohydride. Typical stabilizer additives for electroless copper plating electrolytes are compounds such as mercaptobenzothiazole, thiourea, various other sulfur compounds, cyanide and/or ferrocyanide and/or cobaltocyanide salts, polyethyleneglycol derivatives, heterocyclic nitrogen compounds, methyl butynol, and propionitrile. (ASM Handbook, Vol. 5: Surface Engineering, pp. 311-312). Said first copper layer serves as the plating base for successive electroplating of copper (second copper layer).

## Examples

The invention will now be illustrated by reference to the following non-limiting examples.

General procedure:

Two different types of test substrates were used throughout all examples:

Test coupons type 1 only consisted of the bare dielectric material (Matsushita MC 100 EX: epoxy resin with glass reinforcement but without copper clad) and was used to determine the desired smear removal from the dielectric material by investigating the "weight loss" of said samples after applying the specific method for smear removal as indicated in the respective examples.

Test coupon type 2 consisted of the same dielectric material as substrate material 1 but further comprised a copper layer on both sides.

Both test coupon types had a size of 5 x 5 cm$^2$.

The capability of the different acidic solutions for smear removal was determined by weighting the dried test coupons type 1 on an analytical balance prior and after contacting with the various acidic solutions investigated. The weight loss is given in mg per dm$^2$ of test coupon type 1 surface (surfaces of front- and backside added). A weight loss of dielectric material in such a test in the range of 30 to 80 mg/dm$^2$ is desired. A weight loss below that range indicates that smear is not sufficiently removed from the dielectric material. A weight loss above said range indicates that not only smear but also a not acceptable amount of dielectric material itself is removed.

The copper etch rate of the acidic solutions was determined by weight loss on test coupons type 2. The substrate was weighted before the respective example and afterwards. The resulting weight loss $\Delta$ was calculated as

$$\Delta = [(\text{weight (before treatment)} - \text{weight (after treatement)}] / (\text{substrate surface})$$

A copper etching rate in the range of 0 to 0.2 $\mu$m/min is desired. A copper etching above that range is not acceptable because too much copper is removed during smear removal.

The shelf life of aqueous solutions comprising 60 to 80 wt.-% sulfuric acid and 0.04 to 0.66 mol/l peroxodisulfate ions was determined by measuring the concentration of peroxodisulfate ions by titration with cer(VI)-sulfate each 30 minutes over a period of two hours. In order to simulate the conditions of practical use of such aqueous solutions in the manufacture of printed circuit boards and IC substrates, 3.4 mmol/l of copper ions were added to said aqueous solutions. The concentration of added copper ions was calculated from the concentration of copper ions which would be released into said solution based on a coupon size of 1 dm$^2$ and a standard copper etch rate of 0.08 $\mu$m/min. The temperature of the aqueous solutions was kept at 35 to 40 °C during said tests.

Example 1 (comparative)

Test coupons of type 1 and 2 were contacted with an acidic aqueous solution containing conc. $H_2SO_4$ (97 wt.-% $H_2SO_4$ in water) and 0.25 mol/l (5.7 wt.-%) ammonium peroxodisulfate (example according to EP 0 216 513 A2).

For the first test, the treatment solution temperature was adjusted to 30 °C and the treatment time was 3 min. The weight loss of the test coupon type 1 after treatment with said solution was 708.8 mg/dm$^2$. Accordingly, too much dielectric material is removed by such a treatment solution.

The copper etching rate was 0.031 $\mu$m/min.

For the second test, the treatment solution temperature was adjusted to 35 °C and the treatment time was 15 min. The weight loss of the test coupon after treatment with said solution was 2315 mg/dm$^2$. Again, too much dielectric material is removed from the substrate by such a treatment.

The copper etching rate as determined with a test coupon type 2 was 0.12 $\mu$m/min. Hence, the copper etching rate is acceptable.

During said second test the exothermic reaction leads to a temperature increase of the aqueous solution of 20 K in 15 min. This is not acceptable for safety reasons in the production of printed circuit boards and IC substrates.

Example 2 (comparative)

Test coupons of type 1 and 2 were contacted with an aqueous solution of 200 g/l ammonium peroxodisulfate (example according to US 4,023,998). The treatment solution temperature was adjusted to 25 °C and the treatment time was 1.5 min.

Instead of a weight loss, a weight gain was obtained. The weight gain of the test coupon type 1 after treatment with said solution was 10.3 mg/dm$^2$. The weight gain indicates that smear is not removed from the dielectric material. It is assumed that the dielectric material swells during the treatment with such a treatment solution which is then partially included in the swollen dielectric material. The copper etching rate as determined with a test coupon type 2 was 0.077 $\mu$m/min.

Additional, a test was done with a treatment solution temperature of 35 °C and a treatment time of 15 min.

Instead of weight loss, weight gain was obtained. The weight gain of the test coupon after treatment with said solution was 10.5 mg/dm$^2$.

The copper etching rate as determined with a test coupon type 2 was 0.792 $\mu$m/min. The copper etching rate is too high for a smear removal process.

Example 3 (comparative)

Test coupons of type 1 and 2 were contacted with an acidic aqueous solution containing 75 wt.-% sulfuric acid and 0.22 mol/l ammonium peroxodisulfate. The treatment solution temperature was adjusted to 35 °C and the treatment time was 30 min.

No swelling step in a solution comprising an organic solvent was applied prior to step (ii).

The weight loss of the test coupon after treatment with said solution was 80 mg/dm$^2$. Accordingly, etching of the dielectric material of test coupon type 1 is acceptable.

The copper etching rate as determined with a test coupon type 2 was 0.08 $\mu$m/min which is a desired low copper etching rate.

No more peroxodisulfate ions were detected after 90 min in the presence of 3.4 mmol/l copper ions. Accordingly, the shelf life of said aqueous solution is too low for a reliable method for treatment of recessed structures in a dielectric material for smear removal.

Example 4

The same aqueous solution (75 wt.-% sulfuric acid and 0.22 mol/l ammonium peroxodisulfate) was again investigated after adding 6.8 mmol/l polyethyleneglycol ($M_w$ = 600 g/mol) to said aqueous solution before adding 3.4 mmol/l copper ions (t = 0 min for the shelf life test). The concentration of peroxodisulfate ions only dropped by 15.8 % after 90 min.

Accordingly, the shelf life of the aqueous solution is considered sufficient in the presence of polyethyleneglycol while maintaining the desired low copper etching rate and the required etching of the dielectric material of test coupon type 1.

Example 5

The same aqueous solution (75 wt.-% sulfuric acid and 0.22 mol/l ammonium peroxodisulfate) was again investigated after adding 13.6 mmol/l polyethyleneglycol ($M_w$ = 600 g/mol) to said aqueous solution before adding 3.4 mmol/l copper ions (t = 0 min for the shelf life test). The concentration of peroxodisulfate ions only dropped by 9.5 % after 90 min.

Accordingly, the shelf life of the aqueous solution is considered sufficient in the presence of polyethyleneglycol while maintaining the desired low copper etching rate and the required etching of the dielectric material.

Example 6

The same aqueous solution (75 wt.-% sulfuric acid and 0.22 mol/l ammonium peroxodisulfate) was again investigated after adding 13.6 mmol/l polyethyleneglycol ($M_w$ = 1500 g/mol) to said aqueous solution before adding 3.4 mmol/l copper ions (t = 0 min for the shelf life test). The concentration of peroxodisulfate ions only dropped by 12.3 % after 90 min.

Accordingly, the shelf life of the aqueous solution is considered sufficient in the presence of polyethyleneglycol while maintaining the desired low copper etching rate and the required etching of the dielectric material.

**Claims**

1. A method for treatment of recessed structures in a dielectric material for smear removal comprising, in this order, the steps of

(i) providing a dielectric material comprising at least one recessed structure which contains residues of said dielectric material formed during manufacture of said recessed structures and

(ii) contacting said dielectric material with an aqueous solution comprising 60 to 80 wt.-% sulfuric acid and 0.04 to 0.66 mol/l peroxodisulfate ions and thereby removing said residues of dielectric material from the dielectric material

wherein said aqueous solution further comprises at least one stabilizer additive selected from the group consisting of alcohols, molecular ethers and polymeric ethers.

2. The method for treatment of recessed structures in a dielectric material for smear removal according to claim 1 wherein the dielectric material comprises a thermoplastic polymer selected from the group consisting of epoxy resins, polyimide, cyanate esters, polyester, acrylonitrile-butadiene-styrene copolymer, polycarbonates, acrylonitrile-butadiene-styrene - polycarbonate composites, polyamide and polycyclo-olefine.

3. The method for treatment of recessed structures in a dielectric material for smear removal according to any of the foregoing claims wherein the dielectric material comprises copper structures and/or one or more copper layers.

4. The method for treatment of recessed structures in a dielectric material for smear removal according to any of the foregoing claims wherein the concentration of sulfuric acid in the aqueous solution applied in step (ii) ranges from 65 to 75 wt.-%.

5. The method for treatment of recessed structures in a dielectric material for smear removal according to any of the foregoing claims wherein the concentration of peroxodisulfate ions in the aqueous solution applied in step (ii) ranges from 0.12 to 0.44 mol/l.

6. The method for treatment of recessed structures in a dielectric material for smear removal according to any of the foregoing claims wherein the stabilizer additive is selected from the group consisting of methanol, ethanol, 1-propanole, 2-propanole, 1-butanole, 2-butanole, tert-butanole, 1-pentanol, 2-pentanol, ethylene glycol, propylene glycol, butyl glycol, glycerine and polyvinylalcohol.

7. The method for treatment of recessed structures in a dielectric material for smear removal according to any of the foregoing claims wherein the stabilizer additive is selected from the group consisting of ethylene glycol monoethyl ether, ethylene glycol monobutyl ether, propylene glycol monomethyl ether, propylene glycol monoethyl ether, propylene glycol monobutyl ether, diethylene glycol monomethyl ether, diethylene glycol monoethyl ether, diethylene glycol monopropyl ether, diethylene glycol monobutyl ether, dipropylene glycol monomethyl ether, dipropylene glycol monoethyl ether, dipropylene glycol monopropyl ether, dipropylene glycol monobutylether, triethylene glycol monomethyl ether, triethylene glycol monoethyl ether, triethylene glycol monopropyl ether, triethylene glycol monobutyl ether, tripropylene glycol monomethyl ether, tripropylene glycol monoethyl ether, tripropylene glycol monopropyl ether, tripropylene glycol monobutyl ether and diethylene glycol monoisopropyl ether.

8. The method for treatment of recessed structures in a dielectric material for smear removal according to any of the foregoing claims wherein the stabilizer additive is selected from the group consisting of poly-ethyleneglycol, poly-propyleneglycol, poly-(ethyleneglycol-*ran*-propyleneglycol), poly-(ethyleneglycol)-*block*-poly-(propyleneglycol)-*block*-poly-(ethyleneglycol), and poly-(propyleneglycol)-*block*-poly-(ethyleneglycol)-*block*-poly-(propyleneglycol).

9. The method for treatment of recessed structures in a dielectric material for smear removal according to any of the foregoing claims wherein the concentration of the stabilizer additive ranges from 0.5 to 300 mmol/l.

10. The method for treatment of recessed structures in a dielectric material for smear removal according to any of the foregoing claims wherein the temperature of the aqueous solution is held during step (ii) at a temperature in the range of 10 to 80 °C.

11. The method for treatment of recessed structures in a dielectric material for smear removal according to any of the foregoing claims wherein the dielectric substrate is contacted in step (ii) with the aqueous solution for 1 to 60 min.

12. The method for treatment of recessed structures in a dielectric material for smear removal according to any of the foregoing claims wherein the dielectric substrate is contacted prior to step (ii) with an aqueous solution comprising an organic solvent.

13. The method for treatment of recessed structures in a dielectric material for smear removal according to any of the foregoing claims wherein the dielectric substrate is rinsed with water comprising an alkaline substance after step (ii).

14. The method for treatment of recessed structures in a dielectric substrate for smear removal according to any of the foregoing claims, further comprising the steps of

(iii) contacting said dielectric substrate with a solution comprising ions and/or colloids of a catalytic metal which initiates electroless copper plating and

(iv) contacting said dielectric substrate with an electroless copper plating bath composition and thereby depositing a first copper layer onto the activated dielectric substrate.

15. An aqueous solution for treatment of recessed structures in a dielectric material for smear removal comprising 60 to 80 wt.-% sulfuric acid and 0.04 to 0.66 mol/l peroxodisulfate ions and at least one stabilizer additive selected from the group consisting of alcohols, molecular ethers and polymeric ethers.

## Patentansprüche

1. Verfahren zur Behandlung vertiefter Strukturen in einem dielektrischen Material zur Schmieren("Smear")-Entfernung, umfassend in dieser Reihenfolge die Schritte von

(i) Bereitstellen eines dielektrischen Materials, das wenigstens eine vertiefte Struktur umfasst, die Reste des dielektrischen Materials umfasst, das während einer Herstellung der vertieften Strukturen gebildet wurde, und

(ii) in Kontakt Bringen des dielektrischen Materials mit einer wässrigen Lösung, die 60 bis 80 Gew.-% Schwefelsäure und 0,04 bis 0,66 mol/l Peroxodisulfationen umfasst, und dadurch Entfernen der Reste von dielektrischem Material von dem dielektrischen Material,

wobei die wässrige Lösung ferner wenigstens ein Stabilisatoradditiv umfasst, das aus der Gruppe ausgewählt wird, die aus Alkoholen, molekularen Ethern und polymeren Ethern besteht.

2. Verfahren zur Behandlung vertiefter Strukturen in einem dielektrischen Material zur Schmierenentfernung nach Anspruch 1, wobei das dielektrische Material ein thermoplastisches Polymer umfasst, das aus der Gruppe ausgewählt wird, die aus Epoxidharzen, Polyimid, Cyanatestern, Polyester, Acrylnitril-Butadien-StyrolCopolymer, Polycarbonaten, Acrylnitril-Butadien-Styrol-Polycarbonat-Kompositen, Polyamid und Polycycloolefin besteht.

3. Verfahren zur Behandlung vertiefter Strukturen in einem dielektrischen Material zur Schmierenentfernung nach einem der vorhergehenden Ansprüche, wobei das dielektrische Material Kupferstrukturen und/oder eine oder mehrere Kupferschichten umfasst.

4. Verfahren zur Behandlung vertiefter Strukturen in einem dielektrischen Material zur Schmierenentfernung nach einem der vorhergehenden Ansprüche, wobei die Konzentration an Schwefelsäure in der in Schritt (ii) angewandten wässrigen Lösung von 65 bis 75 Gew.-% reicht.

5. Verfahren zur Behandlung vertiefter Strukturen in einem dielektrischen Material zur Schmierenentfernung nach einem der vorhergehenden Ansprüche, wobei die Konzentration von Peroxodisulfationen in der in Schritt (ii) angewandten wässrigen Lösung von 0,12 bis 0,44 mol/l reicht.

6. Verfahren zur Behandlung vertiefter Strukturen in einem dielektrischen Material zur Schmierenentfernung nach einem der vorhergehenden Ansprüche, wobei das Stabilisatoradditiv aus der Gruppe ausgewählt ist, die aus Methanol, Ethanol, 1-Propanol, 2-Propanol, 1-Butanol, 2-Butanol, tert-Butanol, 1-Pentanol, 2-Pentanol, Ethylenglykol, Propylenglykol, Butylglykol, Glycerin und Polyvinylalkohol besteht.

7. Verfahren zur Behandlung vertiefter Strukturen in einem dielektrischen Material zur Schmierenentfernung nach einem der vorhergehenden Ansprüche, wobei das Stabilisatoradditiv aus der Gruppe ausgewählt wird, die aus Ethylenglykolmonoethylether, Ethylenglykolmonobutylether, Propylenglykolmonomethylether, Propylenglykolmonoethylether, Propylenglykolmonobutylether, Diethylenglykolmonomethylether, Diethylenglykolmonoethylether, Diethylenglykolmonopropylether, Diethylenglykolmonobutylether, Dipropylenglykolmonomethylether, Dipropylenglykolmonoethylether, Dipropylenglykolmonopropylether, Dipropylenglykolmonobutylether, Triethylenglykolmonomethylether, Triethylenglykolmonoethylether, Triethylenglykolmonopropylether, Triethylenglykolmonobutylether, Tripropylenglykolmonomethylether, Tripropylenglykolmonoethylether, Tripropylenglykolmonopropylether, Tripropylenglykolmonobutylether und Diethylenglykolmonoisopropylether besteht.

8. Verfahren zur Behandlung vertiefter Strukturen in einem dielektrischen Material zur Schmierenentfernung nach einem der vorhergehenden Ansprüche, wobei das Stabilisatoradditiv aus der Gruppe ausgewählt wird, die aus Polyethylenglykol, Polypropylenglykol, Poly(ethylenglykol-ran-propylenglykol), Poly(ethylenglykol)-block-poly(propylenglykol)-block-poly(ethylenglykol) und Poly(propylenglykol)-block-poly(ethylenglykol)-block-poly(propylenglykol) besteht.

9. Verfahren zur Behandlung vertiefter Strukturen in einem dielektrischen Material zur Schmierenentfernung nach einem der vorhergehenden Ansprüche, wobei die Konzentration des Stabilisatoradditivs von 0,5 bis 300 mmol/l reicht.

10. Verfahren zur Behandlung vertiefter Strukturen in einem dielektrischen Material zur Schmierenentfernung nach einem der vorhergehenden Ansprüche, wobei die Temperatur der wässrigen Lösung während des Schrittes (ii) auf einer Temperatur in dem Bereich von 10 bis 80 °C gehalten wird.

11. Verfahren zur Behandlung vertiefter Strukturen in einem dielektrischen Material zur Schmierenentfernung nach einem der vorhergehenden Ansprüche, wobei das dielektrische Substrat in Schritt (ii) mit der wässrigen Lösung für 1 bis 60 min in Kontakt gebracht wird.

12. Verfahren zur Behandlung vertiefter Strukturen in einem dielektrischen Material zur Schmierenentfernung nach einem der vorhergehenden Ansprüche, wobei das dielektrische Substrat vor dem Schritt (ii) in Kontakt mit einer wässrigen Lösung gebracht wird, die ein organisches Lösungsmittel umfasst.

13. Verfahren zur Behandlung vertiefter Strukturen in einem dielektrischen Material zur Schmierenentfernung nach einem der vorhergehenden Ansprüche, wobei das dielektrische Substrat nach Schritt (ii) mit Wasser gespült wird, das eine alkalische Substanz umfasst.

14. Verfahren zur Behandlung vertiefter Strukturen in einem dielektrischen Material zur Schmierenentfernung nach einem der vorhergehenden Ansprüche, ferner umfassend die Schritte von

(iii) in Kontakt Bringen des dielektrischen Substrats mit einer Lösung, die Ionen und/oder Kolloide eines katalytischen Materials umfasst, das eine stromlose Kupferabscheidung initiiert, und
(iv) in Kontakt Bringen des dielektrischen Substrats mit einem stromlosen Kupferabscheidungsbad und dadurch Ablagern einer ersten Kupferschicht auf das aktivierte dielektrische Substrat.

15. Wässrige Lösung zur Behandlung vertiefter Strukturen in einem dielektrischen Material zur Schmierenentfernung, umfassend 60 bis 80 Gew.-% Schwefelsäure und 0,04 bis 0,66 mol/l Peroxodisulfationen und wenigstens ein Stabilisatoradditiv, das aus der Gruppe ausgewählt ist, die aus Alkoholen, molekularen Ethern und polymeren Ethern besteht.

## Revendications

1. Procédé pour le traitement de structures en creux dans un matériau diélectrique pour l'élimination de bavures comprenant, dans cet ordre, les étapes consistant à

(i) fournir un matériau diélectrique comprenant au moins une structure en creux qui contient des résidus dudit matériau diélectrique formés pendant la fabrication desdites structures en creux et
(ii) mettre en contact ledit matériau diélectrique avec une solution aqueuse comprenant 60 à 80 % en poids d'acide sulfurique et 0,04 à 0,66 mol/l d'ions peroxodisulfate et de cette manière éliminer lesdits résidus de matériau diélectrique du matériau diélectrique

dans lequel ladite solution aqueuse comprend en outre au moins un additif stabilisant choisi dans le groupe constitué par les alcools, les éthers moléculaires et les éthers polymères.

2. Procédé pour le traitement de structures en creux dans un matériau diélectrique pour l'élimination de bavures selon la revendication 1 dans lequel le matériau diélectrique comprend un polymère thermoplastique choisi dans le groupe constitué par les résines époxy, un polyimide, les esters de l'acide cyanique, un polyester, un copolymère d'acrylonitrile-butadiène-styrène, les polycarbonates, les composites d'acrylonitrile-butadiène-styrène et de polycarbonate, un polyamide et une polycyclooléfine.

**3.** Procédé pour le traitement de structures en creux dans un matériau diélectrique pour l'élimination de bavures selon l'une quelconque des revendications précédentes dans lequel le matériau diélectrique comprend des structures en cuivre et/ou une ou plusieurs couches de cuivre.

**4.** Procédé pour le traitement de structures en creux dans un matériau diélectrique pour l'élimination de bavures selon l'une quelconque des revendications précédentes dans lequel la concentration d'acide sulfurique dans la solution aqueuse appliquée dans l'étape (ii) va de 65 à 75 % en poids.

**5.** Procédé pour le traitement de structures en creux dans un matériau diélectrique pour l'élimination de bavures selon l'une quelconque des revendications précédentes dans lequel la concentration d'ions peroxodisulfate dans la solution aqueuse appliquée dans l'étape (ii) va de 0,12 à 0,44 mol/l.

**6.** Procédé pour le traitement de structures en creux dans un matériau diélectrique pour l'élimination de bavures selon l'une quelconque des revendications précédentes dans lequel l'additif stabilisant est choisi dans le groupe constitué par le méthanol, l'éthanol, le propan-1-ol, le propan-2-ol, le butan-1-ol, le butan-2-ol, le tert-butanol, le pentan-1-ol, le pentan-2-ol, l'éthylèneglycol, le propylèneglycol, le butylglycol, la glycérine et le poly(alcool vinylique).

**7.** Procédé pour le traitement de structures en creux dans un matériau diélectrique pour l'élimination de bavures selon l'une quelconque des revendications précédentes dans lequel l'additif stabilisant est choisi dans le groupe constitué par l'éther monoéthylique d'éthylèneglycol, l'éther monobutylique d'éthylèneglycol, l'éther monométhylique de propylèneglycol, l'éther monoéthylique de propylèneglycol, l'éther monobutylique de propylèneglycol, l'éther monométhylique de diéthylèneglycol, l'éther monoéthylique de diéthylèneglycol, l'éther monopropylique de diéthylèneglycol, l'éther monobutylique de diéthylèneglycol, l'éther monométhylique de dipropylèneglycol, l'éther monoéthylique de dipropylèneglycol, l'éther monopropylique de dipropylèneglycol, l'éther monobutylique de dipropylèneglycol, l'éther monométhylique de triéthylèneglycol, l'éther monoéthylique de triéthylèneglycol, l'éther monopropylique de triéthylèneglycol, l'éther monobutylique de triéthylèneglycol, l'éther monométhylique de tripropylèneglycol, l'éther monoéthylique de tripropylèneglycol, l'éther monopropylique de tripropylèneglycol, l'éther monobutylique de tripropylèneglycol et l'éther monoisopropylique de diéthylèneglycol.

**8.** Procédé pour le traitement de structures en creux dans un matériau diélectrique pour l'élimination de bavures selon l'une quelconque des revendications précédentes dans lequel l'additif stabilisant est choisi dans le groupe constitué par le polyéthylèneglycol, le polypropylèneglycol, le poly(éthylèneglycol-*stat*-propylèneglycol), le polyéthylèneglycol-*bloc*-polypropylèneglycol-*bloc*-polyéthylèneglycol et le polypropylèneglycol-*bloc*-polyéthylèneglycol-*bloc*-polypropylèneglycol.

**9.** Procédé pour le traitement de structures en creux dans un matériau diélectrique pour l'élimination de bavures selon l'une quelconque des revendications précédentes dans lequel la concentration de l'additif stabilisant va de 0,5 à 300 mmol/l.

**10.** Procédé pour le traitement de structures en creux dans un matériau diélectrique pour l'élimination de bavures selon l'une quelconque des revendications précédentes dans lequel la température de la solution aqueuse est maintenue pendant l'étape (ii) à une température dans la plage de 10 à 80 °C.

**11.** Procédé pour le traitement de structures en creux dans un matériau diélectrique pour l'élimination de bavures selon l'une quelconque des revendications précédentes dans lequel le substrat diélectrique est mis en contact dans l'étape (ii) avec la solution aqueuse pendant 1 à 60 min.

**12.** Procédé pour le traitement de structures en creux dans un matériau diélectrique pour l'élimination de bavures selon l'une quelconque des revendications précédentes dans lequel le substrat diélectrique est mis en contact avant l'étape (ii) avec une solution aqueuse comprenant un solvant organique.

**13.** Procédé pour le traitement de structures en creux dans un matériau diélectrique pour l'élimination de bavures selon l'une quelconque des revendications précédentes dans lequel le substrat diélectrique est rincé avec de l'eau comprenant une substance alcaline après l'étape (ii).

**14.** Procédé pour le traitement de structures en creux dans un substrat diélectrique pour l'élimination de bavures selon l'une quelconque des revendications précédentes comprenant en outre les étapes consistant à (iii) mettre en contact ledit substrat diélectrique avec une solution comprenant des ions et/ou des colloïdes d'un métal catalytique qui amorce un cuivrage autocatalytique et

(iv) mettre en contact ledit substrat diélectrique avec une composition de bain de cuivrage autocatalytique et de cette manière déposer une première couche de cuivre sur le substrat diélectrique activé.

15. Solution aqueuse pour le traitement de structures en creux dans un matériau diélectrique pour l'élimination de bavures comprenant 60 à 80 % en poids d'acide sulfurique et 0,04 à 0,66 mol/l d'ions peroxodisulfate et au moins un additif stabilisant choisi dans le groupe comprenant les alcools, les éthers moléculaires et les éthers polymères.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0216513 A
- DE 2010438 A1
- US 4023998 A
- EP 0216513 A2

**Non-patent literature cited in the description**

- ASM Handbook. Surface Engineering, vol. 5, 317-318
- ASM Handbook. Surface Engineering, vol. 5, 311-312